Europäisches Patentamt

European Patent Office

Office européen des brevets

(11) Numéro de publication : **0 107 996**
**B1**

(12) **FASCICULE DE BREVET EUROPÉEN**

(45) Date de publication du fascicule du brevet :
26.03.86

(51) Int. Cl.⁴ : **G 01 R 21/00**

(21) Numéro de dépôt : **83402003.4**

(22) Date de dépôt : **14.10.83**

(54) **Compteur électronique pour la mesure des énergies active et réactive sur un réseau triphasé.**

(30) Priorité : **20.10.82 FR 8217579**

(43) Date de publication de la demande :
**09.05.84 Bulletin 84/19**

(45) Mention de la délivrance du brevet :
**26.03.86 Bulletin 86/13**

(84) Etats contractants désignés :
**AT BE CH DE FR GB IT LI NL SE**

(56) Documents cités :
**EP-A- 0 052 255**
**SIEMENS REVIEW, vol. 44, no. 11, 1977, pages 508-513, Berlin et München, DE H. KOHLER et al.: "Solid-state high-precision kWh and KVarh meter in a 19" plug-in case"**

(73) Titulaire : **ENERTEC**
**12 Place des Etats Unis**
**F-92120 Montrouge (FR)**

(72) Inventeur : **Chiffert, Alain**
**18, rue Edouard Grimaud**
**F-86000 - Poitiers (FR)**
Inventeur : **Galula, William**
**7, rue Barthélémy**
**F-92120 - Montrouge (FR)**
Inventeur : **Rousseau, Michel**
**23, rue Jean-Jacques Rousseau**
**F-92240 - Malakoff (FR)**

(74) Mandataire : **Bentz, Jean-Paul**
**GIERS SCHLUMBERGER Service BREVETS 12, place des Etats-Unis**
**F-92124 Montrouge Cedex (FR)**

Jouve, 18, rue St-Denis, 75001 Paris, France

# 0 107 996

**Description**

La présente invention concerne un compteur électronique pour la mesure des énergies active et réactive sur un réseau triphasé, et plus particulièrement un compteur du type comprenant plusieurs convertisseurs d'intensité et de tension reliés à un dispositif de calcul.

Par convertisseur d'intensité ou de tension, on entend ici un dispositif qui transforme une intensité ou une tension du réseau en un signal d'amplitude compatible avec les circuits de mesure utilisés.

Un dispositif électronique pour la mesure d'énergie est décrit dans le brevet FR-A-2 063 562, ce dispositif fournissant des impulsions dont le nombre représente la quantité d'énergie à mesurer.

Par ailleurs, dans le cas de la mesure des énergies active et réactive sur un réseau triphasé quatre fils, il est classique d'utiliser dans le compteur trois transformateurs de tension composées et trois transformateurs de courant, et, dans le cas d'un réseau trois fils, on utiliserait alors deux transformateurs de tension composées et deux transformateurs de courant. Dans les deux cas, le nombre de transformateurs utilisés est élevé.

En variante, l'article de SIEMENS REVIEW, volume 44, numéro 11, 1977, pages 508-513, Berlin et München, DE, H. KOHLER et al. « Solid-state high precision KWh and KVArh meter in a 19 plug-in case » propose une solution dans laquelle les signaux composés sont obtenus au moyen de circuits électroniques, en particulier d'amplificateurs différentiels ; une telle solution requiert l'emploi de composants électroniques de haute qualité, très coûteux, et dont la dérive au cours du temps risque d'affecter la précision des mesures.

Aussi, la présente invention a pour but, en se basant sur le principe semblable à celui décrit dans le brevet FR-A-2 063 562, de fournir un nouveau compteur électronique capable de mesurer à la fois l'énergie active et l'énergie réactive sur un réseau triphasé avec un nombre restreint de transformateurs.

Conformément à l'invention selon les revendications 1 et 2, le compteur comporte une pluralité de détecteurs d'énergie monophasés ayant chacun une première entrée reliée à un convertisseur d'intensité et une seconde entrée reliée à un convertisseur de tension et délivrant des impulsions d'énergie dont le nombre représente l'énergie détectée par ce détecteur monophasé, et le dispositif de calcul est à microprocesseur et comprend des moyens de cumul commandés par les impulsions délivrées par les détecteurs d'énergie pour fournir les mesures des puissances active et réactive recherchées.

Dans le cas d'un réseau quatre fils équilibré en tension, l'énergie active P et l'énergie réactive Q peuvent s'exprimer sous la forme :

$$P = \vec{V_1} \cdot \vec{I_1} + \vec{V_2} \cdot \vec{I_2} + \vec{V_3} \cdot \vec{I_3} \tag{1}$$

$$Q = \frac{1}{\sqrt{3}} (\vec{U_{23}} \cdot \vec{I_1} + \vec{U_{31}} \cdot \vec{I_2} + \vec{U_{12}} \cdot \vec{I_3}) \tag{2}$$

$\vec{I_1}, \vec{I_2}$ et $\vec{I_3}$ étant les courants de phase ; $\vec{V_1}, \vec{V_2}$ et $\vec{V_3}$ étant les tensions de phase et $\overline{U_{12}}, \overline{U_{23}}$ et $\overline{U_{31}}$ étant les tensions composées.

Le réseau étant supposé équilibré en tension, on peut encore écrire :

$$\vec{V_1} + \vec{V_2} + \vec{V_3} = 0 \tag{3}$$

Comme par ailleurs, $\vec{U_{12}} = \vec{V_1} - \vec{V_2} ; \vec{U_{23}} = \vec{V_2} - \vec{V_3}$ et $\vec{U_{31}} = \vec{V_3} - \vec{V_1}$, il vient des équations (2) et (3) :

$$Q = \frac{1}{\sqrt{3}} (2\vec{I_1} \cdot \vec{V_2} + 2\vec{I_2} \cdot \vec{V_3} + 2\vec{I_3} \cdot \vec{V_1} + \vec{V_1} \cdot \vec{I_1} + \vec{V_2} \cdot \vec{I_2} + \vec{V_3} \cdot \vec{I_3}) \tag{4}$$

Si l'on désigne $\vec{I_1} \cdot \vec{V_1}, \vec{I_1} \cdot \vec{V_2}, \vec{I_2} \cdot \vec{V_2}, \vec{I_2} \cdot \vec{V_3}, \vec{I_3} \cdot \vec{V_3}$ et $\vec{I_3} \cdot \vec{V_1}$ respectivement par $W_1, W_2, W_3, W_4, W_5$ et $W_6$, les relations (1) et (4) peuvent s'écrire :

$$\begin{cases} P = 2\left[\frac{1}{2}(W_1 + W_3 + W_5)\right] \\ Q = \frac{2}{\sqrt{3}}\left[W_2 + W_4 + W_6 + \frac{1}{2}(W_1 + W_3 + W_5)\right] \end{cases} \tag{5}$$

Ainsi, dans le cas d'un réseau quatre fils équilibré, pour la mesure des puissances active et réactive, il suffit que les convertiseurs de tension comprennent uniquement des transformateurs des trois tensions

2

simples du réseau $(\vec{V}_1, \vec{V}_2, \vec{V}_3)$. Il s'agit de transformateurs de lignes qui sont en place et sur lesquels se fait le branchement haute tension du compteur. Par rapport aux systèmes utilisant en plus trois convertisseurs des tensions composées, le gain, dans le compteur selon l'invention, est de trois transformateurs. Les détecteurs d'énergie monophasés sont au nombre de six pour fournir les signaux représentant $W_1$ à $W_6$, c'est-à-dire des impulsions dont les fréquences sont proportionnelles respectivement aux énergies $W_1$ à $W_6$.

Dans le cas d'un réseau trois fils équilibré en tension, l'énergie active P' et l'énergie réactive Q' peuvent s'exprimer sous la forme :

$$P' = \vec{U'_{13}} \cdot \vec{I'_1} + \vec{U'_{23}} \cdot \vec{I'_2} \tag{1'}$$

$$Q' = \frac{1}{\sqrt{3}} [(\vec{U'_{23}} - \vec{U'_{12}}) \vec{I'_1} - (\vec{U'_{31}} - \vec{U'_{12}}) \vec{I'_2}] \tag{2'}$$

$\vec{I'_1}, \vec{I'_2}$ et $\vec{I'_3}$ étant les courants de phase et $\vec{U'_{12}}, \vec{U'_{23}}$ et $\vec{U'_{31}}$ étant les tensions composées.

$$\text{Avec } \vec{U'_{12}} + \vec{U'_{23}} + \vec{U'_{31}} = 0 \tag{3'}$$

il vient

$$Q' = \frac{1}{\sqrt{3}} (2 \vec{I'_1} \cdot \vec{U'_{23}} - 2 \vec{I'_1} \cdot \vec{U'_{13}} - 2 \vec{I'_2} \cdot \vec{U'_{13}} + \vec{I'_1} \cdot \vec{U'_{13}} + \vec{I'_2} \cdot \vec{U'_{23}}) \tag{4'}$$

Si l'on désigne $\vec{I'_1} \cdot \vec{U'_{13}}$ $\vec{I'} \cdot \vec{U'_{23}}$, $-\vec{I'_1} \cdot \vec{U'_{13}}$, $\vec{I'_2} \cdot \vec{U'_{23}}$ et $-\vec{I'_2} \cdot \vec{U'_{13}}$ respectivement par $W'_1, W'_2, W'_3, W'_4$ et $W'_5$, les relations (1') et (4') peuvent s'écrire :

$$\begin{cases} P' = 2\left[\frac{1}{2} (W'_1 + W'_4)\right] \\[2mm] Q' = \frac{2}{\sqrt{3}} \left[W'_2 + W'_3 + W'_5 + \frac{1}{2} (W'_1 + W'_4)\right] \end{cases} \tag{5'}$$

Ainsi dans le cas d'un réseau équilibré trois fils, pour la mesure des puissances active et réactive, il suffit que les convertisseurs de tension comprennent uniquement des transformateurs de ligne de deux tensions composées du réseau ($U'_{13}$ et $U'_{23}$). Par rapport au système qui utiliserait dans le compteur deux convertisseurs de tensions composées, le gain est de deux transformateurs de tension. Les détecteurs d'énergie monophasés sont au nombre de cinq pour fournir les signaux représentant $W'_1$ à $W'_5$, c'est-à-dire des impulsions dont les fréquences sont proportionnelles respectivement aux énergies $W'_1$ à $W'_5$.

Avantageusement, les impulsions délivrées par tous les détecteurs représentent un même quantum d'énergie en valeur absolue. Aussi, pour simplifier le traitement de ces impulsions par le dispositif et compte-tenu du coefficient 1/2 apparaissant dans les relations (5) et (5'), des moyens sont prévus pour diviser par deux la fréquence des impulsions délivrées par les détecteurs monophasés qui détectent les énergies formant les composantes de l'énergie active recherchée.

Avantageusement encore, chaque détecteur d'énergie monophasé comporte deux sorties émettrices d'impulsions ; l'une émet des impulsions délivrées par ce détecteur représentant une énergie positive ; l'autre des impulsions représentant une énergie négative, selon le sens du transfert d'énergie sur le réseau. Par commodité, dans le reste du texte, ces sorties sont dénommées sortie positive et sortie négative, sans aucun lien avec la polarité du signal qu'elles délivrent.

La simple prise en compte directe des impulsions d'énergie positive et négative dans des registres de cumul d'énergie positive et d'énergie négative n'aurait aucune signification physique puisque les quantités P et Q ou P' et Q' telles qu'exprimées par les relations (5) et (5') comportent, indépendamment de leur signe, plusieurs composantes qui peuvent être positives ou négatives. Aussi, selon une particularité du compteur conforme à l'invention, une impulsion d'énergie d'un signe particulier, lorsqu'elle est détectée par le dispositif de calcul, est utilisée pour annuler l'effet d'une impulsion d'énergie précédente de signe opposé, ou pour prédisposer la prise en compte dans un registre de cumul d'une impulsion d'énergie suivante de même signe.

Dans ce but, les moyens de calcul comportent :

un registre de tendance d'énergie active commandé par les impulsions d'énergie active délivrées par les détecteurs monophasés qui détectent les énergies formant les composantes de l'énergie active recherchée, ce registre de tendance évoluant entre un état extrême négatif et un état extrême positif dans un sens en réponse à des impulsions d'énergie positive et dans le sens inverse en réponse à des impulsions d'énergie négative, ledit registre de tendance pouvant prendre au moins un état intermédiaire entre ses états extrêmes,

un registre de cumul d'énergie active positive dont le contenu est incrémenté en réponse à chaque impulsion d'énergie active positive lorsque le registre de tendance d'énergie active est dans son état extrême positif, et

un registre de cumul d'énergie active négative dont le contenu est incrémenté en réponse à chaque impulsion d'énergie active négative lorsque le registre de tendance d'énergie active est dans son état extrême négatif.

De la même manière, pour la détermination de l'énergie réactive, sont prévus un registre de tendance d'énergie réactive, un registre de cumul d'énergie réactive positive et un registre de cumul d'énergie réactive négative semblables à ceux prévus pour la détermination de l'énergie active.

D'autres particularités et avantages du compteur électronique selon l'invention ressortiront à la description faite ci-après, à titre indicatif mais non limitatif, en référence aux dessins annexés sur lesquels :

la figure 1  est un schéma d'ensemble d'un mode de réalisation d'un compteur électronique selon l'invention dans le cas d'un réseau 4 fils,

la figure 2  est un schéma plus détaillé d'un détecteur d'énergie faisant partie d'un compteur de la figure 1,

la figure 3  illustre le principe de traitement des impulsions d'énergie par le dispositif de calcul,

les figures 4 à 6  montrent des ordinogrammes relatifs à différents programmes exécutés dans l'organe de calcul, et

la figure 7  est un schéma partiel d'un mode de réalisation d'un compteur électronique selon l'invention dans le cas d'un réseau 3 fils.

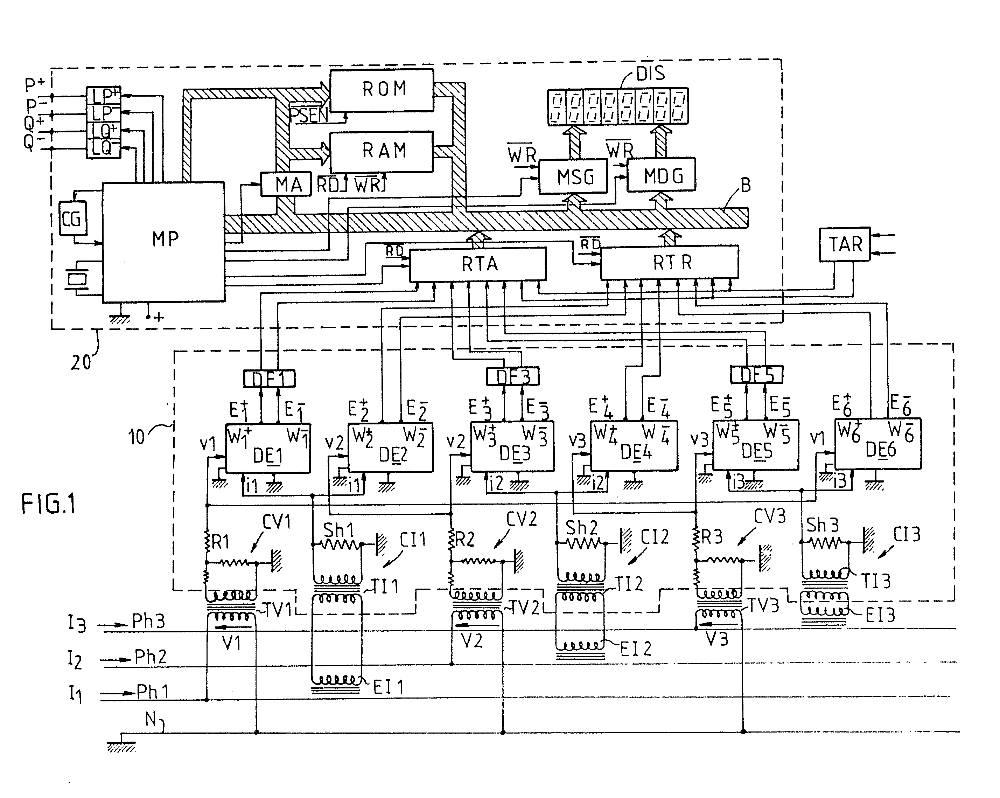

Le compteur illustré par la figure 1 est destiné à la détermination des puissances active et réactive consommées (ou restituées) par un abonné raccordé à un réseau 4 fils équilibré en tension, et comporte un dispositif de mesure 10 et un dispositif de calcul 20.

Trois convertisseurs de tension CT1, CT2 et CT3 délivrent des tensions $\vec{v_1}, \vec{v_2}$ , $\vec{v_3}$ proportionnelles aux tensions simples $V_1$, $V_2$, $V_3$ du réseau. De façon bien connue en soi, chaque convertisseur est formé d'un transformateur de tension (TV1, TV2, TV3) dont le primaire est branché entre la phase correspondante (Ph1, Ph2, Ph3) et le neutre N, et dont le secondaire est branché aux bornes d'un diviseur de potentiel. La tension $\vec{v_1}$, $\vec{v_2}$, $\vec{v_3}$ est prélevée au point milieu du diviseur de potentiel par l'intermédiaire d'une résistance réglable $R_1$, $R_2$, $R_3$ d'impédance élevée.

En outre, trois convertisseurs d'intensité (CI1, CI2, CI3) délivrent des tensions $\vec{i_1}$, $\vec{i_2}$, $\vec{i_3}$ proportionnelles aux intensités $I_1$, $I_2$, $I_3$ des courants des phases Ph1, Ph2, Ph3. De façon également bien connue, chaque convertisseur CI1, CI2, CI3 comprend un transformateur TI1, TI2, TI3 dont le primaire est relié à un enroulement EI1, EI2, EI3 couplé à la phase respective et dont le secondaire est branché sur un shunt Sh1, Sh2, Sh3 aux bornes duquel la tension $\vec{i_1}$, $\vec{i_2}$, $\vec{i_3}$ est disponible. Les transformateurs TV1, TV2 et TV3 et les enroulements EI1, EI2 et EI3 sont en place sur la ligne et ne forment pas partie du compteur tel qu'il se branche sur le réseau, comme le montre la ligne en tirets délimitant le dispositif de mesure 10.

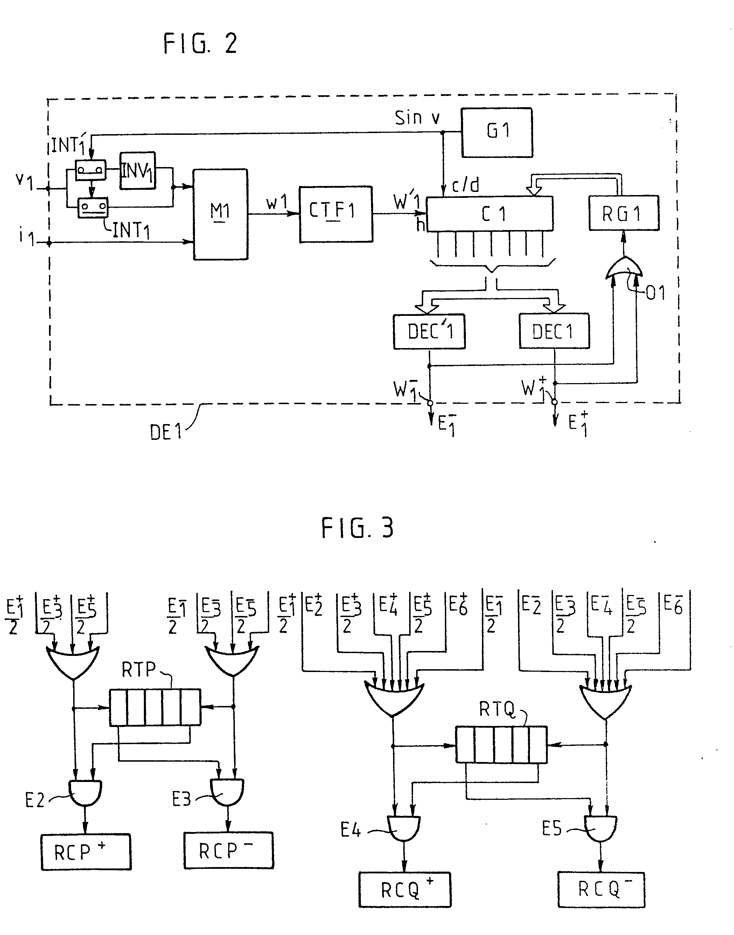

Le dispositif de mesure 10 comporte six détecteurs d'énergie DE1 à DE6 qui délivrent des impulsions de fréquences proportionnelles aux quantités $W_1$ à $W_6$ définies plus haut. A cet effet, les détecteurs DE1 à DE6 reçoivent les couples respectifs de tensions suivants : $(\vec{i_1}, \vec{v_1})$, $(\vec{i_1}, \vec{v_2})$, $(\vec{i_2}, \vec{v_2})$, $(\vec{i_2}, \vec{v_3})$, $(\vec{i_3}, \vec{v_3})$ et $(\vec{i_3}, \vec{v_1})$. Chaque détecteur DE1 à DE6 possède une sortie positive $W_1+$ à $W_6+$ et une sortie négative $W_1-$ à $W_6-$. Les impulsions délivrées par chaque détecteur apparaissent sur sa sortie positive lorsque l'énergie mesurée est prélevée sur le réseau par l'abonné et sur sa sortie négative lorsque l'énergie mesurée est renvoyée sur le réseau par l'abonné. Un mode particulier de réalisation d'un détecteur d'énergie, par exemple DE1 est illustré par la figure 2, les autres détecteurs DE2 à DE6 étant identiques à DE1.

Le détecteur d'énergie DE1 comprend une première entrée qui reçoit la tension $\vec{i_1}$ délivrée par le convertisseur CI1 et une seconde entrée qui reçoit la tension $\vec{v_1}$ délivrée par le convertisseur CV1. La tension $\vec{i_1}$ est appliquée sur une entrée d'un multiplicateur analogique M1 tandis que la tension $\vec{v_1}$ est appliquée sur une autre entrée de ce multiplicateur, soit telle quelle par l'intermédiaire d'un interrupteur INT1, soit déphasée de 180° par l'intermédiaire d'un circuit qui comprend, en série, un interrupteur INT'1 et un inverseur de phase INV1. Les interrupteurs INT1 et INT'1 sont des interrupteurs, par exemple statiques, commandés en synchronisme par un signal d'inversion $S_{inv}$ de manière que l'un soit fermé tandis que l'autre est ouvert. Le signal $S_{inv}$ est engendré par un générateur G1 sous forme d'un train d'impulsions rectangulaires de fréquence fixe $F_{inv}$ définissant des durées égales d'ouverture et de fermeture de chacun des interrupteurs INT1 et INT'1. Le signal analogique $w_1$ produit en sortie du multiplicateur M1 et proportionnel à $\vec{v_1} \cdot \vec{i_1}$, est appliqué à un convertisseur tension/fréquence CTF1 pour être converti en un signal $W'_1$ formé par un train d'impulsions élémentaires de fréquence proportionnelle à $\vec{v_1} \cdot \vec{i_1}$. Ces impulsions sont appliquées à l'entrée d'horloge h d'un compteur-décompteur CD1 dont le fonctionnement dans le sens de comptage ou de décomptage est commandé par le signal d'inversion $S_{inv}$ appliqué à l'entrée c/d de commande de comptage-décomptage. Deux décodeurs DEC1, DEC'1 sont branchés en parallèle sur les sorties du compteur-décompteur CD1. Le décodeur DEC1 délivre une impulsion sur la sortie $W_1+$ lorsque le contenu du compteur-décompteur CD1 atteint une première valeur prédéterminée N1 tandis que le décodeur DEC1 délivre une impulsion sur la

4

sortie $W_1^-$ lorsque le contenu du compteur-décompteur CD1 atteint une seconde valeur prédéterminée N'1. Ces impulsions commandent, par l'intermédiaire d'une porte « OU » 01, la ré-initialisation du compteur à une valeur initiale prédéterminée NO enregistrée dans un registre RG1. Les valeurs N'1, N0 et N1 sont telles que N'1 < N0 < N1.

Lorsqu'aucun courant ne circule dans le shunt Sh1, $i_1$ est nul et la sortie du multiplicateur M1 est normalement au niveau zéro. Le convertisseur CTF1 produit alors des impulsions à une fréquence de base $F_0$. Pendant chaque période du signal d'inversion, un même nombre d'impulsions est successivement compté (ou décompté) puis décompté (ou compté). Les fréquences $F_0$ et $F_{inv}$ et les valeurs N0, N1, N'1 sont choisies pour que le compteur initialisé à la valeur N0 n'atteigne alors aucune des valeurs N1 ou N'1.

Lorsqu'un courant circule dans le shunt, il y a corrélation entre le courant et la tension. Selon le sens de circulation de ce courant, le multiplicateur M1 produira une tension dont l'amplitude sera, au cours des premières demi-périodes de $S_{inv}$ correspondant à la fermeture de INT1 et au fonctionnement de CD1 dans le sens comptage, supérieure ou inférieure à celle de la tension produite au cours des secondes demi-périodes de $S_{inv}$ correspondant à la fermeture de INT'1 et au fonctionnement de CD1 dans le sens de décomptage. Dans le premier cas, la fréquence des impulsions élémentaires $W'_1$ est plus grande lors des premières demi-périodes de $S_{inv}$ que lors des secondes et le contenu de C1 évolue en s'accroissant vers la valeur N1 ; cette valeur étant atteinte, une impulsion d'énergie positive $E_1+$ est produite sur la sortie $W_1+$, le compteur CD1 est ré-initialisé à la valeur N0 et le processus se répète, les impulsions $E_1+$ apparaissant à une fréquence proportionnelle à $W_1$. Dans le second cas, la fréquence des impulsions élémentaires $W'_1$ est plus grande lors des secondes demi-périodes de $S_{inv}$ que lors des premières et le contenu de CD1 évolue en diminuant vers la valeur N'1 ; cette valeur étant atteinte, une impulsion d'énergie négative $E_1^-$ est produite sur la sortie $W_1^-$, le compteur CD1 est ré-initialisé à la valeur N0 et le processus se répète, les impulsions $E_1^-$ apparaissant à une fréquence proportionnelle à $W_1$.

De la même manière, des impulsions d'énergie positive $E_1+$ à $E_6+$ sont délivrées sur les sorties $W_2+$ à $W_6+$ à des fréquences proportionnelles aux quantités $W_2$ à $W_6$ et des impulsions d'énergie négative $E_2^-$ à $E_6^-$ sont délivrées sur les sorties $W_2^-$ à $W_6^-$ à des fréquences proportionnelles aux quantités $W_2$ à $W_6$. Toutes les impulsions $E_1+$ à $E_6+$ et $E_1^-$ à $E_6^-$ représentent le même quantum d'énergie en valeur absolue.

Ces différentes impulsions sont envoyées au dispositif de calcul 20 où sont élaborées les puissances active et réactive recherchées, en appliquant les relations (5) ci-dessus. Compte-tenu du coefficient 1/2 apparaissant dans ces relations devant ($W_1 + W_3 + W_5$), et pour simplifier le calcul, la fréquence des impulsions ($E_1+$, $E_1^-$), ($E_3+$, $E_3^-$) et ($E_5+$, $E_5^-$) est divisée par deux au moyen de diviseurs de fréquence DF1, DF3 et DF5 branchés aux sorties respectivement de DE1, DE3 et DE5 (figure 1). Ainsi, le dispositif de calcul reçoit des impulsions dont les fréquences sont proportionnelles respectivement à $W_1/2$, $W_2$, $W_3/2$, $W_4$, $W_5/2$ et $W_6$. En choisissant pour tous les détecteurs d'énergie des valeurs correspondant à N1 identiques entre elles, les impulsions d'énergie positives reçues par le dispositif de calcul sont proportionnelles à $W_1/2$, $W_2$, $W_3/2$, $W_4$, $W_5/2$ et W/6 avec un même coefficient de proportionnalité K+. De même, en choisissant des valeurs correspondant à N'1 égales entre elles, les impulsions d'énergie négatives reçues par le dispositif de calcul sont proportionnelles à $W_1/2$, $W_2$, $W_3/2$, $W_4$, $W_5/2$ et $W_6$ avec un même coefficient de proportionnalité K⁻.

Si N1 — N0 = N0 — N'1, les coefficients K+ et K⁻ sont égaux entre eux. Par contre, si N1 — N0 ≠ N0 — N'1, ces coefficients sont différents. Par exemple, si N1 — N0 = k (N0 — N'1), la fréquence des impulsions d'énergie négative est k fois plus élevée que celle des impulsions d'énergie positive pour une même valeur absolue d'énergie. On tiendra compte de ce fait soit en divisant la fréquence des impulsions d'énergie négative par la valeur k avant de les appliquer au dispositif de calcul, soit en ne prenant en compte qu'une impulsion d'énergie négative sur k au moment de l'acquisition des impulsions d'énergie dans le dispositif de calcul.

Dans ce qui suit, on supposera, sauf indications contraires, que K+ = K⁻, c'est-à-dire que toutes les impulsions d'énergie, à fréquences égales, représentent une même énergie en valeur absolue.

Le dispositif de calcul 20 (figure 1) comprend un microprocesseur MP, associé à une mémoire morte de programme ROM, à une mémoire vive RAM et à des circuits d'entrées/sorties. Dans le cas où le microprocesseur n'a pas de mémoire interne, on peut prévoir un bus multiplexé B sur lequel transitent à la fois les données et les adresses basses. Un dispositif de mémorisation d'adresses MA formé par un ensemble de bascules permet de mémoriser les adresses sur le bus B à un instant déterminé par un signal ALE produit par le microprocesseur MP.

La mémoire de programme ROM a ses entrées d'adresses basses reliées à MA et ses entrées d'adresses hautes reliées directement au microprocesseur MP. Ses sorties de données sont connectées au bus B, l'ordre d'écriture sur le bus étant fourni par un signal $\overline{PSEN}$ produit par le microprocesseur.

La mémoire vive RAM a ses entrées d'adresses reliées à MA et ses entrées/sorties de données reliées au bus B. Les ordres d'écriture et de lecture sur le bus B sont donnés par des signaux $\overline{RD}$ et $\overline{WR}$ produits par le microprocesseur MP.

Les circuits d'entrées/sorties comprennent un dispositif de mémorisation des impulsions d'énergie reçues du dispositif de mesure 10. Ce dispositif de mémorisation comprend par exemple deux registres tampons à trois états, l'un RTA recevant les impulsions produites en sortie des diviseurs de fréquence DF1, DF3, DF5 et servant à la détermination de la puissance active et l'autre RTR recevant les impulsions produites en sortie des détecteurs d'énergie DE2, DE4 et DE6. Les entrées restantes du registre RTA et du registre RTR peuvent être utilisées pour l'entrée de signaux relatifs aux périodes tarifaires et produits par un circuit TAR recevant les signaux conventionnels indicatifs de changement de période tarifaire. La sélection des registres RTA et RTR est réalisée au moyen de signaux de contrôle respectifs produits par le microprocesseur MP et l'écriture sur le bus B du contenu de ces registres est commandée par le signal $\overline{\text{RD}}$.

Les circuits d'entrées/sorties comprennent aussi un dispositif de mémorisation connecté entre le bus B et un organe d'affichage DIS formé par un ensemble de caractères ou « digits » à sept segments. L'affichage est par exemple multiplexé. Dans un premier temps, un groupe de signaux binaires représentant les états des segments est mémorisé dans une mémoire MSG formée par un ensemble de bascules et sélectionnée par un signal de contrôle particulier produit par le microprocesseur.

Ensuite, un groupe de signaux représentant les états des caractères est mémorisé dans une mémoire MDG également formée par un ensemble de bascules et sélectionnée par un signal de contrôle particulier produit par le microprocesseur. L'ordre de mémorisation dans les mémoires MSG et MDG est donné par le signal $\overline{\text{WR}}$.

Le microprocesseur MP a encore quatre sorties reliées à des circuits à relais LP+, LP⁻, LQ+ et LQ⁻ afin de produire sur des sorties respectives du compteur des impulsions représentant les puissances mesurées active positive P+, active négative P⁻, réactive positive Q+ et réactive négative Q⁻.

Enfin, le microprocesseur est relié à un circuit CG remplissant, comme connu en soi, la fonction de « chien de garde », à un cristal servant à la production de la fréquence de son horloge interne et à des bornes portées aux potentiels de référence et d'alimentation.

La structure décrite ci-avant du dispositif de calcul n'est qu'un mode particulier de réalisation. Tout autre système de traitement à microprocesseur permettant d'atteindre les mêmes résultats pourrait être utilisé.

Avant de décrire plus en détail certaines des opérations effectuées par le dispositif de calcul 20, un mode préféré de traitement des impulsions d'énergie est décrit ci-après en référence à la figure 3.

Pour la détermination de l'énergie active, on prend en compte les impulsions $E_1+$, $E_3+$, $E_5+$, $E_1^-$, $E_3^-$ et $E_5^-$ après division de leur fréquence par deux. Chaque impulsion d'énergie positive est appliquée à une entrée d'un registre de tendance d'énergie active RTP tandis que chaque impulsion d'énergie négative est appliquée à une autre entrée du registre RTP. Le registre RTP peut évoluer dans un sens ou dans l'autre entre un état extrême négatif et un état extrême positif. Dans l'état extrême positif, le registre RTP fournit un signal indicateur qui ouvre une porte E2 à chaque impulsion d'énergie positive reçue, tandis que, dans l'état extrême négatif, ce registre fournit un signal indicateur qui ouvre une porte E3 à chaque impulsion d'énergie négative reçue. Le registre RTP peut prendre au moins un, et de préférence plusieurs états intermédiaires entre ses états extrêmes. En supposant que, le registre RTP étant dans son état extrême positif, une impulsion d'énergie positive est reçue, cette impulsion est prise en compte à travers la porte E2 et comptabilisée dans un registre RCP+ de cumul d'énergie active positive, mais si une impulsion d'énergie négative est reçue, cette impulsion n'est pas prise en compte mais place le registre RTP dans son état intermédiaire le plus proche de l'état extrême positif. Dans ce dernier cas, si l'impulsion suivante reçue est positive, elle n'est pas prise en compte mais ramène le registre RTP dans son état extrême positif et si cette impulsion suivante reçue est négative, elle fait accomplir au registre RTP un nouveau pas vers son état extrême négatif. Si le registre RTP parvient dans cet état, et si une impulsion d'énergie négative se présente, elle est prise en compte à travers la porte E3 et comptabilisée dans un registre RCP⁻ de cumul d'énergie négative. Ainsi, chaque impulsion reçue d'énergie n'est pas directement prise en compte dans un registre de cumul, mais est traitée dans le contexte changeant d'un bilan continuel des impulsions précédentes.

On peut par exemple utiliser comme registre de tendance un registre à décalage à n positions toutes occupées par des « 0 » sauf une occupée par un « 1 » constituant l'indicateur de tendance. Chaque impulsion d'énergie positive décale le registre dans un sens (à droite) jusqu'à ce que l'indicateur se trouve dans la position la plus à droite (état extrême positif) tandis que chaque impulsion d'énergie négative décale le registre dans l'autre sens (à gauche) jusqu'à ce que l'indicateur se trouve dans la position la plus à gauche (état extrême négatif). Lorsque l'indicateur se trouve dans une position extrême et qu'une impulsion du même signe est reçue, alors cette impulsion est cumulée tandis que la position de l'indicateur reste inchangée.

Pour la détermination de l'énergie réactive, on prend en compte les impulsions $E_1+$, $E_3+$, $E_5+$, $E_1^-$, $E_3^-$, $E_5^-$ après division de leur fréquence par deux et les impulsions $E_2+$, $E_4+$, $E_6+$, $E_2^-$, $E_4^-$ et $E_6^-$. La prise en compte des impulsions reçues est réalisée comme pour la détermination de l'énergie active, en utilisant un registre RTQ de tendance d'énergie réactive. Dans son état extrême positif, le registre RTQ autorise par son indicateur de tendance la prise en compte des impulsions d'énergie positive à travers une porte E4 et leur comptabilisation dans un registre RCQ+ de cumul d'énergie réactive positive et, dans son état extrême négatif, le registre RTQ autorise par son indicateur de tendance la prise en compte des impulsions d'énergie négative à travers une porte E5 et leur comptabilisation dans un registre RCQ⁻ de cumul d'énergie réactive négative.

Le dispositif de calcul 20 est programmé de manière à accomplir notamment les tâches suivantes :

6

a) acquisition des impulsions d'énergie et des périodes tarifaires,

b) sortie des impulsions de relais P+, P⁻, Q+, Q⁻,

c) changement de la valeur affichée,

d) calcul de P et Q suivant les relations (5).

Une tâche de fond exécute le traitement des impulsions acquises — tâche (d) — .

Une tâche prioritaire déclenchée par les signaux d'interruption produits par un séquenceur exécute les tâches (a) à (c).

Pour le passage de la tâche prioritaire à la tâche de fond, on utilise par exemple deux mémoires structurées en piles PILEA et PILER associées à deux pointeurs respectifs PTPILA et PTPILR. Le programme d'acquisition des impulsions d'énergie remplit les piles PILEA et PILER à partir de la scrutation des registres tampons RTA et RTR, respectivement. Un programme de fond (calcul de P et Q) vide les piles PILEA et PILER.

De même pour le passage de la tâche de fond à la tâche (b), on utilise quatre compteurs d'impulsions relais CP+, CP⁻, CQ+, CQ⁻ qui sont incrémentés par le programme de fond (calcul de P et Q) et décrémentés par le programme sous interruption (sortie des impulsions de relais).

L'acquisition des impulsions d'énergie est réalisée en réponse à chaque signal d'interruption, ceux-ci étant produits par le séquenceur avec une période telle qu'aucune impulsion d'énergie ne risque d'être perdue même lorsque la puissance sur le réseau est maximale.

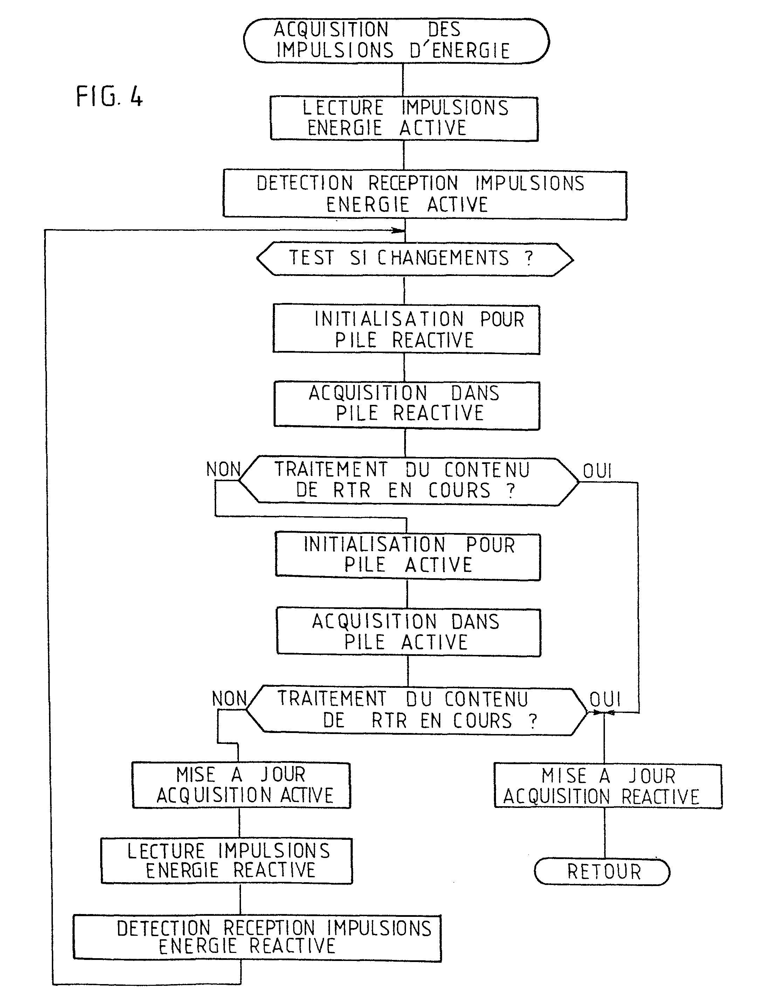

En bref, pour l'acquisition des impulsions d'énergie, on détecte d'abord la réception de nouvelles impulsions d'énergie par le registre RTA pour introduire l'information correspondante dans la pile PILER et dans la pile PILEA (puisque les impulsions d'énergie comptabilisées pour l'énergie active le sont aussi pour l'énergie réactive) puis on détecte la réception de nouvelles impulsions d'énergie par le registre RTR pour introduire l'information correspondante dans la pile PILER. Les opérations réalisées sont notamment les suivantes (figure 4) :

lecture du contenu de RTA (« lecture impulsions énergie active ») ;

comparaison du mot lu avec celui contenu dans un registre RMA — dans lequel est conservé le mot lu dans RTA au cours de l'interruption précédente —, afin de détecter un changement d'état d'un bit de ce mot dans l'intervalle (« détection réception impulsions d'énergie active ») ; on notera que la détection de chaque changement d'état des signaux d'énergie reçus revient à appliquer le coefficient 2 apparaissant dans les relations (5) ;

examen du résultat de comparaison (« test si changements ») ;

si ce test est négatif (pas de changement détecté en RTA), détection de la réception de nouvelles impulsions en RTR (« traitement du contenu de RTR ») ; si ce test est positif, élaboration de l'information à introduire dans la pile PILER (« initialisation pour pile réactive ») ;

introduction dans la pile PILER de l'information élaborée (« acquisition dans pile réactive ») ;

test si le « traitement du contenu de RTR » est en cours ;

ce test étant négatif, élaboration de l'information à introduire dans la pile PILEA (« initialisation pour pile active ») ;

introduction dans la pile PILEA de l'information élaborée (« acquisition dans pile active ») ;

test si le « traitement du contenu de RTR » est en cours ;

ce test étant négatif, mise à jour du contenu de RMA avec le mot lu dans RTA (« mise à jour acquisition active ») ;

lecture du contenu de RTR (« lecture impulsions d'énergie réactive ») ;

comparaison du mot lu avec celui contenu dans un registre RMR — dans lequel est conservé le mot lu dans RTR au cours de l'interruption précédente —, afin de détecter un changement d'état dans l'intervalle (« détection réception impulsions énergie réactive ») ;

retour en « test si changements » ;

si ce test est négatif (pas de changement détecté en RTR), passage à la phase « traitement du contenu de RTR » ; si ce test est positif, passage à la phase « initialisation pour pile réactive » ;

« acquisition dans pile réactive » ;

test « traitement du contenu de RTR en cours » ;

ce test étant positif, mise à jour du contenu de RMR avec le mot lu dans RTR (« mise à jour acquisition réactive ») ; et

retour à la tâche de fond.

Le traitement des impulsions d'énergie acquises et le calcul des énergies active et réactive recherchées est effectué au cours du programme de fond. On suppose que trois périodes tarifaires différentes sont prévues (nuit N, jour J et pointe P). Dans la mémoire RAM sont alors mémorisées en permanence 12 valeurs d'énergie, à savoir les valeurs d'énergie cumulée active positive et négative, et réactive positive et négative pour chaque période tarifaire N, J et P, soit :

P+N, P⁻N, Q+N, Q⁻N, P+J, P⁻J, Q+J, Q⁻J, P+P, P⁻P, Q+P et Q⁻P.

Chaque valeur d'énergie cumulée est en représentation B C D (décimale codée binaire), et comprend une partie entière de huit chiffres (codée sur quatre octets) et un reste de huit chiffres (codé aussi sur quatre octets). On suppose par ailleurs que les registres de tendance RTP, RTQ sont des registres à décalage comprenant un nombre pair de positions.

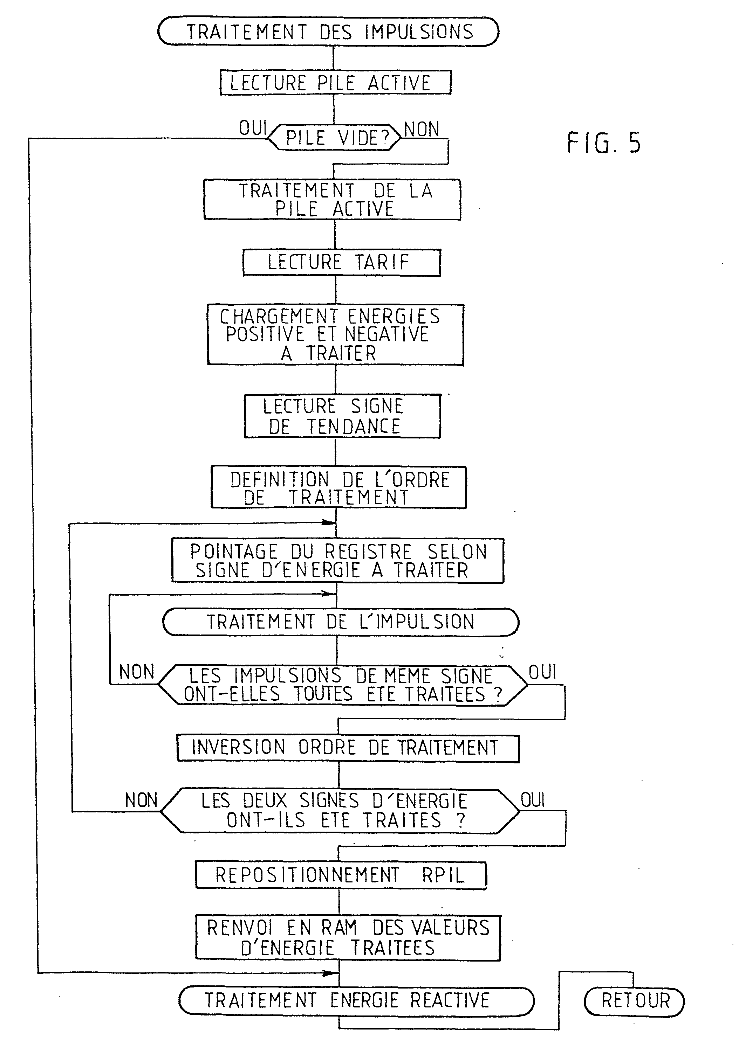

Le programme de traitement des impulsions (figure 5) comprend les opérations suivantes (on ne décrira que le traitement des impulsions en vue du calcul de la puissance active) :

lecture de la pile PILEA (« lecture pile active ») ;

test de « pile vide » par examen du pointeur de pile PTPILA ;

si le test est positif, on passe en fin de programme de traitement des impulsions d'énergie active ; si le test est négatif, on charge un registre RPIL par la valeur contenue dans la première case de la pile PILEA et l'on décale toutes les autres valeurs de la pile d'une case pour le traitement prochain (« traitement de la pile active ») ;

lecture de l'information de période tarifaire — cette information est fournie sur deux entrées du registre RTA et se trouve donc codée sur deux bits dans le mot chargé dans le registre RPIL — (« lecture tarif ») ;

chargement dans un registre auxiliaire de calcul RAUX des valeurs d'énergie actives positive et négative correspondant au tarif lu (« chargement énergies positive et négative à traiter ») ;

détermination de l'information de signe de tendance SENS+ ou SENS— selon que l'indicateur du registre de tendance se trouve dans la moitié droite du registre RTP ou dans la moitié gauche de ce registre et positionnement d'un indicateur MSENS qui mémorise l'information de signe de tendance (« lecture signe de tendance ») ;

détermination de l'ordre de traitement des énergies active positive et négative, l'énergie traitée en premier étant celle de signe opposé à celui de la tendance (« définition de l'ordre de traitement ») ;

sélection dans le registre RAUX de la valeur d'énergie correspondant à celle à traiter en premier (« pointage du registre selon signe d'énergie à traiter ») ;

exécution du sous-programme « traitement de l'impulsion » (voir plus loin) sur la première impulsion d'énergie de RPIL dont le signe est celui de l'énergie en cours de traitement ;

traitements successifs des autres impulsions d'énergie de ce signe par test « les impulsions de même signe ont-elles toutes été traitées ? » puis, le test étant négatif, retour au sous-programme « traitement de l'impulsion » ;

lorsque le test précédent devient positif, inversion de l'ordre de traitement des énergies (« inversion ordre de traitement ») ;

test « les deux signes d'énergie ont-ils été traités ? », puis le test étant négatif, retour en « pointage du registre selon signe d'énergie à traiter » ;

les impulsions de l'énergie de l'autre signe étant toutes traitées et le test « les deux signes d'énergie ont-ils été traités » étant devenu positif, repositionnement du registre RPIL dans son état du début de traitement « repositionnement RPIL » ;

renvoi dans la RAM des nouvelles valeurs calculées d'énergie active positive et négative aux emplacements correspondants à la période tarifaire relue dans RPIL (« renvoi en RAM des valeurs d'énergies traitées ») ;

test « les énergies active et réactive ont-elles été traitées ? » ;

si le test est négatif, traitement de l'énergie réactive de la même façon que, ci-avant, l'énergie active et, si le test est positif, « retour ».

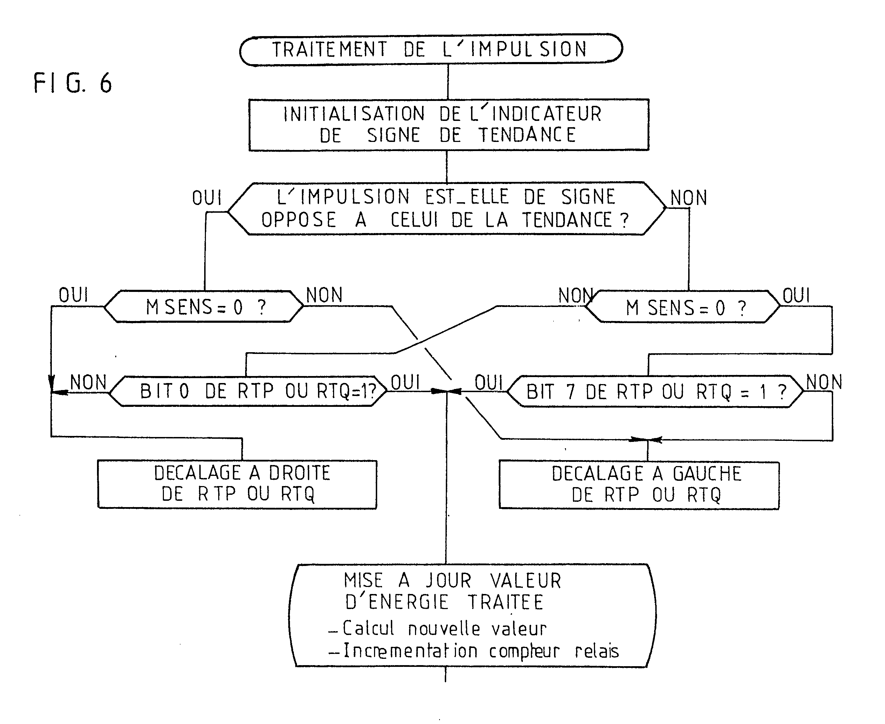

Le sous-programme de « traitement de l'impulsion » comprend les opérations suivantes (figure 6) :

initialisation de l'indicateur de signe de tendance correspondant à l'énergie traitée (« initialisation MSENS ») ;

test « l'impulsion est-elle de signe opposé à celui de la tendance ? » ;

si ce test est négatif (après inversion de l'ordre de traitement), test de la valeur de l'indicateur de signe de tendance (« MSENS = 0 ? ») ; si cette valeur est nulle (tendance négative) et que le registre de tendance est dans son état extrême négatif avec l'indicateur de tendance dans la position la plus à gauche de ce registre (« Bit 7 de RTP ou RTQ = 1 »), passage au sous-programme « mise à jour de la valeur d'énergie » ; si la valeur de MSENS est nulle (tendance négative) mais que le registre de tendance n'est pas dans son état extrême négatif, décalage de ce registre d'un pas à gauche (« décalage à gauche de RTP ou RTQ ») ; si la valeur de MSENS n'est pas nulle (tendance positive) et que le registre de tendance est dans son état extrême positif avec l'indicateur de tendance dans la position la plus à droite de ce registre (« Bit 0 de RTP ou RTQ = 1 »), passage au sous-programme « mise à jour de la valeur d'énergie » ; enfin, si la valeur de MSENS n'est pas nulle (tendance positive) mais que le registre de tendance n'est pas dans son état extrême positif, décalage de ce registre d'un pas à droite (« décalage à droite de RTP ou RTQ ») ;

dans le cas où maintenant le test « l'impulsion est-elle de signe opposé à celui de la tendance ? » est positif (premier passage), si la valeur de MSENS est nulle (tendance négative) test « MSENS = 0 ? » positif, passage à la phase « décalage à droite de RTP ou RTQ » et si la valeur de MSENS n'est pas nulle (tendance positive — test « MSENS = 0 ? » négatif) ; passage à la phase « décalage à gauche de RTP ou RTQ ».

Ainsi, sont d'abord traitées les impulsions de signe opposé à celui de la tendance, seules les impulsions de même signe pouvant ensuite être éventuellement prises en compte pour modifier la valeur de l'énergie traitée. On notera aussi que la valeur de l'indicateur MSENS est ré-initialisée à chaque nouvelle exécution du sous-programme « traitement de l'impulsion », cette valeur pouvant avoir changé par suite de l'exécution précédente de ce sous-programme.

Le sous-programme « mise à jour de la valeur d'énergie » comprend une phase de calcul qui consiste à additionner à la valeur d'énergie pointée dans le registre RAUX la quantité que représente l'impulsion validée. D'une façon générale, cette quantité est affectée d'un coefficient k pour l'énergie active et d'un coefficient

$$\frac{k}{\sqrt{3}}$$

pour l'énergie réactive. Ce coefficient k peut tenir compte du rapport de transformation haute tension/basse tension. En variante, et pour simplifier le processus, on peut choisir k = 1 et tenir compte de ce rapport de transformation au niveau de la facturation. Après prise en compte de l'impulsion d'énergie validée, on obtient dans le registre RAUX, une nouvelle valeur d'énergie avec une nouvelle partie entière et un nouveau reste. Le sous-programme « mise à jour de la valeur d'énergie » comprend aussi une phase d'incrémentation du compteur d'impulsions relais correspondant, le contenu de ce compteur étant augmenté d'un nombre égal à l'accroissement de la valeur entière de l'énergie traitée.

La commande des relais d'impulsions LP+, LP⁻, LQ+ et LQ⁻ est une tâche prioritaire exécutée tous les $n_1$ signaux d'interruption émis par le séquenceur. A cet effet, un compteur reçoit les signaux d'interruption sur son entrée d'horloge et, lorsqu'il atteint la valeur $n_1$, est ré-initialisé à la valeur zéro et commande l'exécution d'un programme de traitement des impulsions relais. Pour chaque relais, ce programme comprend les opérations suivantes :

acquisition de l'état du relais ;

si le relais est fermé, ouverture du relais ;

et

si le relais est ouvert et si le compteur d'impulsions relais associé n'est pas à zéro, fermeture du relais et décrémentation de ce compteur d'une unité.

Enfin, l'affichage des valeurs d'énergie conservées en RAM est une tâche prioritaire exécutée tous les $n_2$ signaux d'interruption émis par le séquenceur. Pour permettre une lecture aisée, avec une fréquence de renouvellement des valeurs affichées pas trop basse, on choisit par exemple $n_2$ pour que l'affichage de chaque valeur dure quelques secondes. Un compteur reçoit les signaux d'interruption sur son entrée d'horloge et, lorsqu'il atteint la valeur $n_2$, est ré-initialisé à la valeur 0 et commande l'affichage d'une nouvelle valeur. A cet effet, il est prévu une table d'affichage qui donne l'ordre dans lequel les valeurs d'énergie sont affichées et qui est associée à un pointeur d'affichage. La table comporte un ensemble de 12 emplacements contenant chacun l'adresse et le code d'affichage d'une valeur d'énergie particulière. A chaque fois qu'une nouvelle valeur d'énergie est affichée, le pointeur d'affichage est incrémenté. L'information affichée comprend une partie d'identification de l'énergie concernée et le nombre représentant la valeur de celle-ci.

Dans ce qui précède, on a envisagé le cas où, pour tenir compte du coefficient 1/2 dans les relations (5), des diviseurs de fréquence par deux sont branchés aux sorties des détecteurs d'énergie DE1, DE3 et DE5.

En variante, les impulsions $E_1+$, $E_1^-$, $E_3+$, $E_3^-$ et $E_5+$, $E_5^-$ pourront être appliquées directement au dispositif de calcul, comme les autres impulsions, et ledit coefficient 1/2 est pris en compte au cours du programme d'acquisition des impulsions d'énergie en ne détectant, pour les mots lus dans le registre RTA, non pas tous les changements d'états, mais seulement les changements se produisant dans le même sens.

Par ailleurs, on a décrit un mode particulier de réalisation d'un compteur selon l'invention dans le cas d'un réseau 4 fils équilibré en tension.

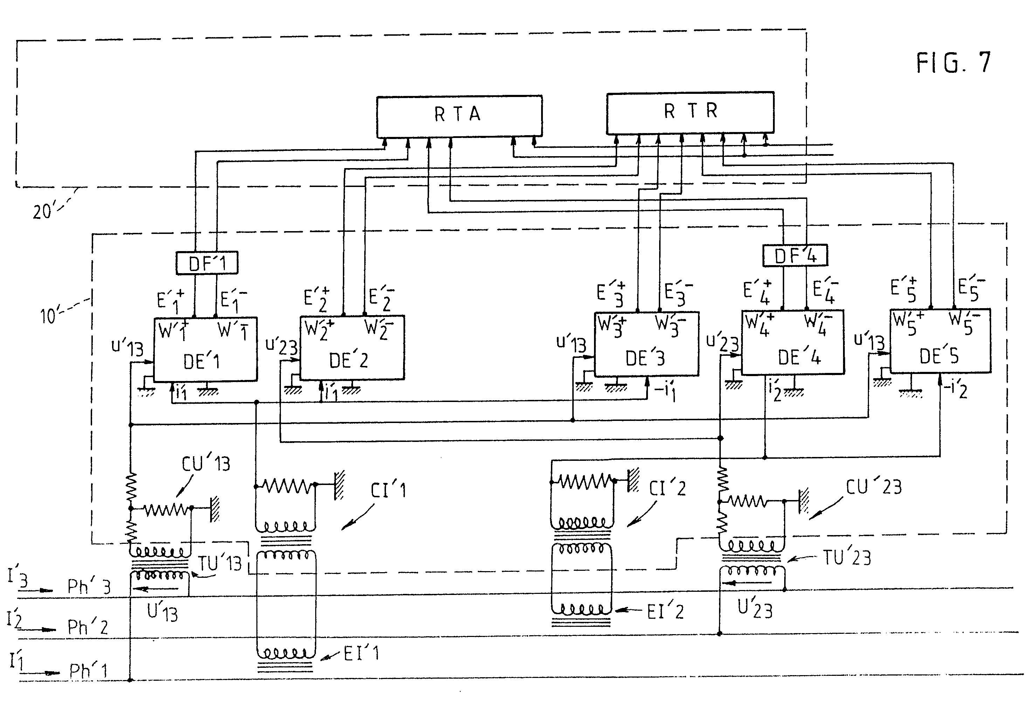

Or, l'invention est également applicable aux réseaux trois fils comme le montre la figure 7. Dans ce cas, le comptage est effectué sur la base des équations (5') données plus haut. A cet effet, deux convertisseurs de potentiel CV'1, CV'2 fournissent des tensions $\vec{u}'_{13}$ et $\vec{u}'_{23}$ proportionnelles aux tensions composées $U'_{13}$ et $U'_{23}$ du réseau. Ces convertisseurs comprennent deux transformateurs de potentiel TU'13 et TU'23 dont les primaires sont connectés respectivement entre les phases Ph'1 et Ph'3 et entre les phases Ph'2 et Ph'3. Les tensions $\vec{u}'_{13}$ et $\vec{u}'_{23}$ sont prélevées en sortie de diviseurs de potentiel, branchés aux secondaires des transformateurs TU'13 et TU'23. Par ailleurs, deux convertisseurs de courant TI'1 et TI'2, analogues à ceux utilisés avec le réseau 4 fils, fournissent des tensions $\vec{i}'_1$ et $\vec{i}'_2$ proportionnelles aux courants de phase $I'_1$ et $I'_2$. Les transformateurs TU'13 et TU'23 ainsi que les enroulements EI'1 et EI'2 des convertisseurs TI'1 et TI'2 sont en place sur la ligne et servent au raccordement haute tension du compteur.

Le dispositif de mesure 10' comprend encore cinq détecteurs d'énergie DE'1 et DE'5, analogues à ceux utilisés avec le réseau 4 fils, et fournissant des impulsions d'énergie dont les fréquences sont proportionnelles aux quantités $W'_1$ à $W'_5$. Les détecteurs d'énergie DE'1 à DE'5 reçoivent respectivement les couples de tensions suivants : $(\vec{i}'_1, \vec{u}'_{13})$, $(\vec{i}'_1, \vec{u}'_{23})$, $(-\vec{i}'_1, \vec{u}'_{13})$, $(\vec{i}'_2, \vec{u}'_{23})$ et $(-\vec{i}'_2, \vec{u}'_{23})$. Pour tenir compte du signe affectant les tensions $\vec{i}'_1$ et $\vec{i}'_2$ appliquées à DE'3 et DE'5, on inverse les entrées courant de ces détecteurs par rapport à DE'1 et DE'4. Par ailleurs, pour tenir compte du coefficient 1/2 apparaissant dans les relations (5'), deux diviseurs de fréquence par deux DF'1 et DF'4 peuvent être branchés aux sorties des détecteurs DE'1 et DE'4. Chaque détecteur DE'1 à DE'4 a une sortie positive $W'_1+$ à $W'_5+$ sur laquelle sont délivrées les impulsions d'énergie positives $E'_1+$ à

$E'_5+$ et une sortie négative $W'_1^-$ à $W'_5^-$ sur laquelle sont délivrées les impulsions d'énergie négatives $E'_1^-$ à $E'_5^-$.

Le dispositif de calcul 20' est identique à celui décrit plus haut dans le cas du réseau 4 fils si ce n'est que le registre RTA reçoit quatre signaux d'impulsions d'énergie ($E'_1+$, $E'_1^-$, $E'_4+$, $E'_4^-$) au lieu de six, le registre RTR recevant les six signaux restants ($E'_2+$, $E'_2^-$, $E'_3+$, $E'_3^-$, $E'_5+$ et $E'_5^-$).

## Revendications

1. Compteur électronique pour la mesure des énergies ou des puissances active et réactive sur un réseau triphasé, comprenant plusieurs convertisseurs d'intensité et de tension ($TI_1$, $TI_2$, $TI_3$, $TV_1$, $TV_2$, $TV_3$), une pluralité de détecteurs d'énergie monophasés ($DE_1$ à $DE_6$) ayant chacun une première entrée reliée à un convertisseur d'intensité et une seconde entrée reliée à un convertisseur de tension et délivrant des impulsions d'énergie dont le nombre représente l'énergie détectée par ce détecteur monophasé, et un dispositif de comptage (20) recevant lesdites impulsions d'énergie, caractérisé en ce que, pour la mesure des énergies ou des puissances active et réactive sur un réseau quatre fils (fig. 1), les convertisseurs de tension ($TV_1$, $TV_2$, $TV_3$) comprennent uniquement des transformateurs des trois tensions simples du réseau et les détecteurs d'énergie fournissent des impulsions dont les fréquences sont proportionnelles respectivement aux quantités $I_1 \cdot V_1$, $I_1 \cdot V_2$, $I_2 \cdot V_2$, $I_2 \cdot V_3$, $I_3 \cdot V_3$, et $I_3 \cdot V_1$, dans lesquelles $I_1$, $I_2$ et $I_3$ désignent les courants de phase et $V_1$, $V_2$ et $V_3$ désignent les tensions de phase, et en ce que le dispositif de comptage (20) est à micro-processeur et comprend des moyens de cumul (RTA, RTR) commandés par les impulsions délivrées par les détecteurs d'énergie pour fournir les mesures des énergies ou des puissances active et réactive recherchées.

2. Compteur électronique pour la mesure des énergies ou des puissances active et réactive sur un réseau triphasé, comprenant plusieurs convertisseurs d'intensité et de tension ($TI_1$, $TI_2$, $TI_3$, $TV_1$, $TV_2$, $TV_3$), une pluralité de détecteurs d'énergie monophasés ($DE_1$ à $DE_6$) ayant chacun une première entrée reliée à un convertisseur d'intensité et une seconde entrée reliée à un convertisseur de tension et délivrant des impulsions d'énergie dont le nombre représente l'énergie détectée par ce détecteur monophasé, et un dispositif de comptage (20) recevant lesdites impulsions d'énergie, caractérisé en ce que, pour la mesure des énergies ou des puissances active et réactive sur un réseau trois fils (fig. 7), les convertisseurs de tension ($TV_1$, $TV_2$, $TV_3$) comprennent uniquement des transformateurs de deux tensions composées du réseau et les détecteurs d'énergie ($DE_1$ à $DE_6$) fournissent des impulsions dont les fréquences sont proportionnelles respectivement aux quantités $I'_1 \cdot U'_{13}$, $I'_1 \cdot U'_{23}$, — $I'_1 \cdot U'_{13}$, $I'_2 \cdot U'_{23}$ et — $I'_2 \cdot U'_{13}$ dans lesquelles $I'_1$ et $I'_2$ sont les courants de deux phases et $U'_{13}$ et $U'_{23}$ sont les tensions composées entre chacune de ces phases et la troisième, et en ce que le dispositif de comptage (20) est à micro-processeur et comprend des moyens de cumul (RTA, RTR) commandés par les impulsions délivrées par les détecteurs d'énergie pour fournir les mesures des énergies ou des puissances active et réactive recherchées.

3. Compteur selon l'une quelconque des revendications 1 à 2, caractérisé en ce que les impulsions délivrées par les détecteurs représentent toutes un même quantum d'énergie en valeur absolue.

4. Compteur selon la revendication 3, caractérisé en ce qu'il comporte des moyens pour diviser par deux la fréquence des impulsions délivrées par les détecteurs monophasés qui détectent les énergies formant les composantes de l'énergie active recherchée.

5. Compteur selon l'une quelconque des revendications 1 à 4, caractérisé en ce que chaque détecteur d'énergie monophasé ($DE_1$ à $DE_6$) comporte une sortie positive et une sortie négative, les impulsions délivrées par ce détecteur étant des impulsions d'énergie positive ($E_1+$) ou négative ($E_1^-$) apparaissant sur sa sortie positive ou sur sa sortie négative selon le sens du transfert d'énergie sur le réseau.

6. Compteur selon la revendication 5, caractérisé en ce que les moyens de cumul comportent :

un registre de tendance d'énergie active (RTP) commandé par les impulsions d'énergie active délivrées par les détecteurs monophasés qui détectent les énergies formant les composantes de l'énergie active recherchée, ce registre de tendance évoluant entre un état extrême négatif et un état extrême positif dans un sens en réponse à des impulsions d'énergie positive et dans le sens inverse en réponse à des impulsions d'énergie négative, ledit registre de tendance pouvant prendre au moins un état intermédiaire entre ses états extrêmes,

un registre de cumul d'énergie active positive (RCP+) dont le contenu est incrémenté en réponse à chaque impulsion d'énergie active positive lorsque le registre de tendance d'énergie active est dans son état extrême positif,

un registre de cumul d'énergie active négative (RCP—) dont le contenu est incrémenté en réponse à chaque impulsion d'énergie active négative lorsque le registre de tendance d'énergie active est dans son état extrême négatif,

un registre de tendance d'énergie réactive (RTQ) commandé par les impulsions d'énergie réactive délivrées par les détecteurs monophasés qui détectent les énergies formant les composantes de l'énergie réactive recherchée, ce registre de tendance d'énergie réactive évoluant entre un état extrême négatif et un état extrême positif dans un sens en réponse à des impulsions d'énergie positive et dans le sens inverse en réponse à des impulsions d'énergie négative, ledit registre de tendance d'énergie réactive pouvant prendre au moins un état intermédiaire entre ses états extrêmes,

un registre de cumul d'énergie réactive positive (RCQ+) dont le contenu est incrémenté en réponse à chaque impulsion d'énergie réactive positive lorsque le registre de tendance d'énergie réactive est dans son état extrême positif, et

un registre de cumul d'énergie réactive négative (RCQ—) dont le contenu est incrémenté en réponse à chaque impulsion d'énergie réactive négative lorsque le registre de tendance d'énergie réactive est dans son état extrême négatif.

7. Compteur selon la revendication 6, caractérisé en ce que chaque registre de tendance peut prendre une pluralité d'états intermédiaires entre ses états extrêmes.

8. Compteur selon l'une quelconque des revendications 1 à 7, caractérisé en ce que chaque détecteur d'énergie comporte un circuit multiplicateur ($M_1$) recevant les signaux appliqués à la première et à la seconde entrée du détecteur et produisant une tension représentative du produit de ces signaux, un circuit convertisseur tension-fréquence ($CTF_1$) délivrant des impulsions élémentaires à une fréquence proportionnelle à la tension produite par le circuit multiplicateur, un compteur-décompteur ($C_1$) qui reçoit lesdites impulsions élémentaires, des moyens ($G_1$) pour commander le fonctionnement du compteur-décompteur dans le sens du comptage ou de décomptage et un circuit de décodage ($DEC_1$) qui commande l'émission d'une impulsion d'énergie positive et le repositionnement du compteur-décompteur à une valeur initiale ($N_0$) lorsque le contenu du compteur-décompteur atteint une première valeur prédéterminée ($N_1$) et qui commande l'émission d'une impulsion d'énergie négative et le repositionnement du compteur-décompteur à ladite valeur initiale ($N_0$) lorsque le contenu du compteur-décompteur atteint une seconde valeur prédéterminée ($N'_1$).

9. Compteur selon la revendication 8, caractérisé en ce que lesdits moyens de commande du fonctionnement du compteur-décompteur comportent un générateur d'impulsions d'inversion de fréquence fixe ($G_1$) pour commander le fonctionnement du compteur-décompteur dans le sens du comptage et dans le sens du décomptage alternativement pendant des périodes de même durée, et en ce que des moyens de déphasage ($INT_1$, $INT'_1$) commandés par les impulsions d'inversion sont prévus pour inverser, au rythme desdites impulsions d'inversion, la phase de l'un des signaux reçus par le circuit multiplicateur.

## Claims

1. An electronic counter for measuring the active and reactive energies or powers on a three-phase network, comprising several current and voltage converters ($TI_1$, $TI_2$, $TI_3$, $TV_1$, $TV_2$, $TV_3$), a plurality of single-phase energy detectors ($DE_1$ to $DE_6$) each having a first input coupled to a current converter and a second input coupled to a voltage converter and delivering energy pulses, the number of which represents the energy detected by this single-phase detector, and a counting device (20) receiving said energy pulses, characterized in that, for measuring the active and reactive energies or powers on a four-wire network (fig. 1), the voltage converters ($TV_1$, $TV_2$, $TV_3$) only comprise transformers for the three single-phase voltages of the network and the energy detectors provide pulses, the frequencies of which are proportional to the quantities $I_1 \cdot V_1$, $I_1 \cdot V_2$, $I_2 \cdot V_2$, $I_2 \cdot V_3$, $I_3 \cdot V_3$ and $I_3 \cdot V_1$, respectively where $I_1$, $I_2$ and $I_3$ indicate the phase currents and $V_1$, $V_2$ and $V_3$ indicate the phase voltages, and in that the counting device (20) includes a microprocessor and comprises running-total means (RTA, RTR) controlled by the pulses delivered by the energy detectors in order to provide the measurements of the desired active and reactive energies and powers.

2. An electronic counter for measuring the active and reactive energies and powers on a three-phase network, comprising several current and voltage converters ($TI_1$, $TI_2$, $TI_3$, $TV_1$, $TV_2$, $TV_3$), a plurality of single-phase energy detectors ($DE_1$ to $DE_6$) each having a first input coupled to a current converter and a second input coupled to a voltage converter and delivering energy pulses, the number of which represents the energy detected by this single-phase detector, and a counting device (20) receiving said energy pulses, characterized in that, for measuring the active and reactive energies or powers on a three-wire network (fig. 7), the voltage converters ($TV_1$, $TV_2$, $TV_3$) only comprise transformers for two phase-to-phase voltages of the network and the energy detectors ($DE_1$ to $DE_6$) provide pulses, the frequencies of which are proportional to the quantities $I'_1 \cdot U'_{13}$, $I'_1 \cdot U'_{23}$, $— I'_1 \cdot U'_{13}$, $I'_2 \cdot U'_{23}$ and $— I'_2 \cdot U'_{13}$, respectively, where $I'_1$ and $I'_2$ are the currents of both phases and $U'_{13}$ and $U'_{23}$ are the phase-to-phase voltages between each of these phases and the third one, and in that the counting device (20) includes a microprocessor and comprises running-total means (RTA, RTR) controlled by the pulses delivered by the energy detectors in order to provide the measurements of the desired active and reactive energies and powers.

3. A counter according to any of claims 1 to 2, characterized in that the pulses delivered by the detectors all represent the same energy quantum in absolute value.

4. A counter according to claim 3, characterized in that it comprises means for dividing by two the frequency of the pulses delivered by the single-phase detectors which detect the energies forming the components of the desired active energy.

11

5. A counter according to any of claims 1 to 4, characterized in that each single-phase detector ($DE_1$ to $DE_6$) comprises a positive output and a negative output, the pulses delivered by this detector being pulses of positive ($E_1+$) or negative ($E_1-$) energy occuring on its positive output or its negative output according to the direction of energy transfer on the network.

6. A counter according to claim 5, characterized in that the running-total means comprise :

an active energy tendency register (RTP) controlled by the active energy pulses delivered by the single-phase detectors which detect the energies forming the components of the desired active energy, which tendency register switches between an extreme negative state and an extreme negative state in one direction, in response to negative energy pulses, wherein said tendency register can assume at least one intermediate state between its extreme states,

a positive active energy running-total register (RCP+) whose contents is incremented in response to each positive active energy pulse when the active energy tendency register is in its extreme positive state,

a negative active energy running-total register (RCP—) whose contents is incremented in response to each negative active energy pulse when the active energy tendency register is in its extreme negative state,

a reactive energy tendency register (RTQ) controlled by the reactive energy energy pulses delivered by the singler-phase detectors which detect the energies forming the components of the desired reactive energy, which reactive energy tendency register switches between an extreme negative state and an extreme positive state in one direction, in response to positive energy pulses, and in the opposite direction in response to negative energy pulses, and in opposite direction in response to negative energy pulses, wherein said reactive energy tendency register can assume at least one intermediate state between its extreme states,

a positive reactive energy running-total register (RCQ+) whose contents is incremented in response to each positive reactive energy pulse when the ractive energy tendency register is in its extreme positive state, and

a negative reactive energy running-total register (RCQ—) whose contents is incremented in response to each negative reactive energy pulse when the reactive energy tendency register is in its extreme negative state,

7. A counter according to claim 6, characterized in that each tendency register can assume a plurality of intermediate states between its extreme states.

8. A counter according to any of claims 1 to 7, characterized in that each energy detector comprises a multiplier circuit ($M_1$) receiving the signals applied to the first and to the second inputs of the detector and providing a voltage representative of the product of these signals, a voltage-frequency converter ($CTF_1$) delivering unit pulses proportional to the voltage generated by the multiplier-circuit, a reversible counter ($C_1$) which receives said unit pulses, means ($G_1$) to cause the reversible counter to count up or down and a decoder circuit ($DEC_1$) which controls the transmission of a positive energy pulse and the resetting of the reversible counter to an initial value ($N_0$) when the contents of the reversible counter reaches a first predetermined value ($N_1$) and which controls the transmission of a negative energy pulse and the resetting of the reversible counter to said initial value ($N_0$) when the contents of the reversible counter reaches a second predetermined value ($N'_1$).

9. A counter according to claim 8, characterized in that said means for controlling the operation of the reversible counter comprise a fixed frequency inversion pulse generator ($G_1$) to cause the reversible counter to alternately count up and count down during time intervals of same duration, and in that phase shifting means ($INT_1$, $INT'_1$) controlled by the inversion pulses are provided to revert, at the rate of said inversion pulses, the phase of one of the signals received by multiplier circuit.

**Patentansprüche**

1. Elektronischer Zähler zur Messung der reellen und reaktiven Energien oder Leistungen an einem Dreiphasennetz, mit mehreren Intensitäts- und Spannungs-Umsetzern ($TI_1$, $TI_2$, $TI_3$, $TV_1$, $TV_2$, $TV_3$), einer Mehrzahl von Einphasen-Energiedetektoren ($DE_1$ bis $DE_6$), die jeweils einen ersten, mit einem Intensitäts-Umsetzer verbundenen Eingang und einen zweiten, mit einem Spannungs-Umsetzer verbundenen Eingang aufweisen und Energieimpulse abgeben, deren Anzahl die durch diesen Einphasen-Detektor erfaßte Energie darstellt, und mit einer Zählvorrichtung (20), welche diese Energieimpulse empfängt, dadurch gekennzeichnet, daß zur Messung der reellen und reaktiven Energien oder Leistungen an einem vieradrigen Netz (Fig. 1) die Spannungs-Umsetzer ($TV_1$, $TV_2$, $TV_3$) lediglich Transformatoren für die drei einfachen Spannungen des Netzes umfassen und die Energiedetektoren Impulse liefern, deren Frequenzen jeweils proportional zu den Größen $I_1 \cdot V_1$, $I_1 \cdot V_2$, $I_2 \cdot V_2$, $I_2 \cdot V_3$, $I_3 \cdot V_3$, bzw. $I_2 \cdot V_1$ sind, worin $I_1$, $I_2$ und $I_3$ die Phasen-Ströme und $V_1$, $V_2$ und $V_3$ die Phasen-Spannungen bezeichnen, und daß die Zählvorrichtung (20) mit Mikroprozessor arbeitet und Summiermittel (RTA, RTR) umfaßt, welche durch die Impulse gesteuert werden, die von den Energiedetektoren abgegeben werden, um die gesuchten Meßgrößen für die reellen und reaktiven Energien oder Leistungen zu liefern.

2. Elektronischer Zähler zur Messung der reellen und reaktiven Energien oder Leistungen an einem Dreiphasennetz, mit mehreren Intensitäts- und Spannungs-Umsetzern ($TI_1$, $TI_2$, $TI_3$, $TV_1$, $TV_2$, $TV_3$), einer Mehrzahl von einphasigen Energiedetektoren ($DE_1$ bis $DE_6$) die jeweils einen ersten, mit einem Intensitäts-Umsetzer verbundenen Eingang und einen zweiten, mit einem Spannungs-Umsetzer verbundenen Eingang aufweisen und Energieimpulse abgeben, deren Anzahl die durch diesen einphasigen Detektor festgestellte Energie darstellt, und mit einer Zählvorrichtung (20), welche die genannten Energieimpulse empfängt, dadurch gekennzeichnet, daß zur Messung der reellen und reaktiven Energien oder Leistungen an einem dreiadrigen Netz (Fig. 7) die Spannungs-Umsetzer ($TV_1$, $TV_2$, $TV_3$) lediglich Transformatoren für zwei zusammengesetzte Spannungen des Netzes aufweisen und die Energiedetektoren ($DE_1$ bis $DE_6$) Impulse liefern, deren Frequenzen jeweils proportional zu den Größen $I'_1 \cdot U'_{13}$, $I'_1 \cdot U'_{23}$, — $I'_1 \cdot U'_{13}$, $I'_2 \cdot U'_{23}$ bzw. — $I'_2 \cdot U'_{13}$ sind, worin $I'_1$ und $I'_2$ die Ströme von zwei Phasen sowie $U'_{13}$ und $U'_{23}$ die zusammengesetzten Spannungen zwischen jeder dieser Phasen und der dritten Phase sind, und daß die Zählvorrichtung (20) mit einem Mikroprozessor arbeitet und Summiermittel (RTA, RTR) aufweist, welche durch die Impulse gesteuert werden, die von den Energiedetektoren abgegeben werden, um die gesuchten Meßgrößen für die reellen und reaktiven Energien oder Leistungen zu liefern.

3. Zähler nach Anspruch 1 oder 2, dadurch gekennzeichnet, daß die von den Detektoren abgegebenen Impulse alle im Absolutwert dieselbe Energiegröße darstellen.

4. Zähler nach Anspruch 3, dadurch gekennzeichnet, daß er Mittel umfaßt, um die Frequenz derjenigen Impulse durch zwei zu teilen, welche von den Einphasen-Detektoren abgegeben werden, welche die Energien erfassen, die die Komponenten der gesuchten reellen Energie bilden.

5. Zähler nach einem der Ansprüche 1 bis 4, dadurch gekennzeichnet, daß jeder Einphasen-Energiedetektor ($DE_1$ bis $DE_6$) einen positiven Ausgang und einen negativen Ausgang aufweist, wobei die von diesem Detektor abgegebenen Impulse Impulse positiver Energie ($E_1+$) oder negativer Energie ($E_1-$) sind, welche an seinem positiven Ausgang oder negativen Ausgang erscheinen, je nach der Richtung der Energieübertragung in dem Netz.

6. Zähler nach Anspruch 5, dadurch gekennzeichnet, daß die Summiermittel umfassen :

ein Tendenz-Register für die reelle Energie (RTP), welches durch die Impulse reeller Energie gesteuert wird, die von den Einphasen-Detektoren abgegeben werden, welche die Energien erfassen, welche die Komponenten der gesuchten reellen Energie bilden, wobei dieses Tendenz-Register zwischen einem extremen negativen Zustand und einem extremen positiven Zustand in einem Sinne ansprechend auf Impulse positiver Energie und im entgegengesetzten Sinne ansprechend auf Impulse negativer Energie evoluiert, wobei dieses Tendenz-Register wenigstens einen Zwischenzustand zwischen seinen Extremzuständen einnehmen kann,

ein Summierregister für die reelle positive Energie (RCP+), dessen Inhalt ansprechend auf jeden positiven Impuls reeller Energie inkrementiert wird, wenn das Tendenz-Register reeller Energie in seinem positiven Extremzustand ist,

ein Summierregister für negative reelle Energie (RCP—), dessen Inhalt ansprechend auf jeden negativen Impuls reeller Energie inkrementiert wird, wenn das Tendenz-Register reeller Energie in seinem negativen Extremzustand ist,

ein Tendenz-Register reaktiver Energie (RTQ), welches durch die Impulse reaktiver Energie gesteuert wird, die von den Einphasen-Detektoren abgegeben werden, welche die Energien erfassen, die die Komponenten der gesuchten reaktiven Energie bilden, wobei dieses Tendenz-Register reaktiver Energie zwischen einem negativen Extremzustand und einem positiven Extremzustand in einem Sinne ansprechend auf Impulse positiver Energie und im entgegengesetzten Sinne ansprechend auf Impulse negativer Energie evoluiert, wobei dieses Tendenz-Register reaktiver Energie wenigstens einen Zwischenzustand zwischen seinen Extremzuständen annehmen kann,

ein Summier-Register positiver reaktiver Energie (RCQ+), dessen Inhalt ansprechend auf jeden Impuls positiver reaktiver Energie inkrementiert wird, wenn das Tendenz-Register reaktiver Energie in seinem positiven Extremzustand ist, und

ein Summier-Register negativer reaktiver Energie (RCQ—), dessen Inhalt ansprechend auf jeden Impuls negativer reaktiver Energie inkrementiert wird, wenn das Tendenz-Register reaktiver Energie sich in seinem negativen Extremzustand befindet.

7. Zähler nach Anspruch 6, dadurch gekennzeichnet, daß jedes Tendenz-Register eine Mehrzahl von Zwischenzuständen zwischen seinen Extremzuständen einnehmen kann.

8. Zähler nach einem der Ansprüche 1 bis 7, dadurch gekennzeichnet, daß jeder Energiedetektor eine Multiplizierschaltung ($M_1$) umfaßt, welche die Signale empfängt, die an den ersten und an den zweiten Eingang des Detektors angelegt werden, und eine Spannung erzeugt, welche das Produkt dieser Signale darstellt, eine Spannungs-Frequenz-Umschaltung ($CTF_1$) enthält, welche elementare Impulse bei einer Frequenz abgibt, die proportional zu der Spannung ist, welche durch die Multiplizierschaltung erzeugt wird, einen Aufwärts/Abwärts-Zähler ($C_1$) umfaßt, welcher die genannten elementaren Impulse empfängt, Mittel ($G_1$) zur Steuerung des Betriebs des Aufwärts/Abwärts-Zählers im Aufwärts- oder Abwärtssinn und eine Decodierschaltung ($DEC_1$) umfaßt, welche die Abgabe eines Impulses positiver Energie und die Rückstellung des Aufwärts/Abwärts-Zählers auf einen Anfangswert ($N_0$) steuert, wenn der Inhalt des Aufwärts/Abwärts-Zählers einen ersten vorbestimmten Wert ($N_1$) erreicht, und die Abgabe eines Impulses negativer Energie und die Rückstellung des Aufwärts/Abwärts-Zählers auf den genannten

Empfangswert ($N_0$) steuert, wenn der Inhalt des Aufwärts/Abwärts-Zählers einen zweiten vorbestimmten Wert ($N'_1$) erreicht.

9. Zähler nach Anspruch 8, dadurch gekennzeichnet, daß die genannten Mittel zum Steuern des Betriebs des Aufwärts/Abwärts-Zählers einen Festfrequenz-Invertier-Impulsgenerator ($G_1$) umfassen, um den Betrieb des Aufwärts/Abwärts-Zählers im Aufwärtssinne und im Abwärtssinne abwechselnd während Perioden gleicher Dauer zu steuern, und daß Phasenschiebermittel ($INT_1$, $INT'_1$), welche durch die Invertier-Impulse gesteuert werden, vorgesehen sind, um im Rhythmus der genannten Invertier-Impulse die Phase eines der Signale zu invertieren, welche die Multiplizierschaltung empfängt.

FIG.1

0 107 996

FIG. 2

FIG. 3

FIG. 4

```
         ╭─────────────────────────╮
         │  ACQUISITION    DES     │
         │  IMPULSIONS D'ENERGIE   │
         ╰─────────────────────────╯
                     │
         ┌─────────────────────────┐
         │  LECTURE  IMPULSIONS    │
         │  ENERGIE  ACTIVE        │
         └─────────────────────────┘
                     │
     ┌─────────────────────────────────┐
     │  DETECTION RECEPTION IMPULSIONS  │
     │  ENERGIE  ACTIVE                 │
     └─────────────────────────────────┘
                     │
          ╱─────────────────────────╲
          ⟨   TEST  SI CHANGEMENTS ? ⟩
          ╲─────────────────────────╱
                     │
         ┌─────────────────────────┐
         │  INITIALISATION  POUR   │
         │  PILE  REACTIVE         │
         └─────────────────────────┘
                     │
         ┌─────────────────────────┐
         │  ACQUISITION   DANS     │
         │  PILE  REACTIVE         │
         └─────────────────────────┘
                     │
   NON ╱─────────────────────────────╲ OUI
      ⟨  TRAITEMENT  DU CONTENU       ⟩
      ⟨  DE  RTR  EN  COURS  ?        ⟩
       ╲─────────────────────────────╱
                     │
         ┌─────────────────────────┐
         │  INITIALISATION  POUR   │
         │  PILE  ACTIVE           │
         └─────────────────────────┘
                     │
         ┌─────────────────────────┐
         │  ACQUISITION DANS       │
         │  PILE  ACTIVE           │
         └─────────────────────────┘
                     │
   NON ╱─────────────────────────────╲ OUI
      ⟨  TRAITEMENT  DU CONTENU       ⟩
      ⟨  DE   RTR EN COURS  ?         ⟩
       ╲─────────────────────────────╱
```

MISE  A  JOUR
ACQUISITION ACTIVE

MISE  A  JOUR
ACQUISITION REACTIVE

LECTURE IMPULSIONS
ENERGIE REACTIVE

RETOUR

DETECTION RECEPTION IMPULSIONS
ENERGIE REACTIVE

TRAITEMENT DES IMPULSIONS

LECTURE PILE ACTIVE

OUI — PILE VIDE? — NON

FIG. 5

TRAITEMENT DE LA PILE ACTIVE

LECTURE TARIF

CHARGEMENT ENERGIES POSITIVE ET NEGATIVE A TRAITER

LECTURE SIGNE DE TENDANCE

DEFINITION DE L'ORDRE DE TRAITEMENT

POINTAGE DU REGISTRE SELON SIGNE D'ENERGIE A TRAITER

TRAITEMENT DE L'IMPULSION

NON — LES IMPULSIONS DE MEME SIGNE ONT-ELLES TOUTES ETE TRAITEES ? — OUI

INVERSION ORDRE DE TRAITEMENT

NON — LES DEUX SIGNES D'ENERGIE ONT-ILS ETE TRAITES ? — OUI

REPOSITIONNEMENT RPIL

RENVOI EN RAM DES VALEURS D'ENERGIE TRAITEES

TRAITEMENT ENERGIE REACTIVE

RETOUR

4

FIG. 6

TRAITEMENT DE L'IMPULSION

INITIALISATION DE L'INDICATEUR DE SIGNE DE TENDANCE

L'IMPULSION EST_ELLE DE SIGNE OPPOSE A CELUI DE LA TENDANCE ?
OUI / NON

M SENS = 0 ?
OUI / NON

M SENS = 0 ?
NON / OUI

BIT 0 DE RTP OU RTQ = 1 ?
NON / OUI

BIT 7 DE RTP OU RTQ = 1 ?
OUI / NON

DECALAGE A DROITE DE RTP OU RTQ

DECALAGE A GAUCHE DE RTP OU RTQ

MISE A JOUR VALEUR D'ENERGIE TRAITEE
- Calcul nouvelle valeur
- Incrementation compteur relais

0 107 996

FIG. 7